(19) Europäisches Patentamt / European Patent Office / Office européen des brevets

(11) **EP 4 220 208 A1**

(12) **EUROPEAN PATENT APPLICATION**
published in accordance with Art. 153(4) EPC

(43) Date of publication:
**02.08.2023 Bulletin 2023/31**

(21) Application number: **21870977.2**

(22) Date of filing: **16.07.2021**

(51) International Patent Classification (IPC):
**G01R 31/389** $^{(2019.01)}$    **G01R 27/02** $^{(2006.01)}$

(52) Cooperative Patent Classification (CPC):
**G01R 27/02; G01R 31/389**

(86) International application number:
**PCT/CN2021/106829**

(87) International publication number:
**WO 2022/062599 (31.03.2022 Gazette 2022/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.09.2020 CN 202011021904**

(71) Applicant: **Datang NXP Semiconductors (Xuzhou) Co., Ltd.**
**Xuzhou, Jiangsu 221000 (CN)**

(72) Inventor: **VAN LAMMEREN, J.p.m**
**Jiangsu 226400 (CN)**

(74) Representative: **EP&C**
**P.O. Box 3241**
**2280 GE Rijswijk (NL)**

(54) **BATTERY IMPEDANCE MEASUREMENT CIRCUIT**

(57) Provided is a battery impedance measurement circuit (400), comprising: a signal generator (410), connected to at least one battery cell (401), used for inputting a drive current to each battery cell (401); an analog-to-digital converter (420), connected to the two ends of the battery cell (401), and used for converting the analog voltage signal from the battery cell (401) into a digital voltage signal; an impedance extraction module (430), connected to the signal generator (410) and the analog-to-digital converter (420), and used for extracting an impedance signal associated with the impedance characteristics of the battery cell (401); and a digital filter (440), which receives the impedance signal from the impedance extraction module (430), the digital filter (440) having attenuation notches at a plurality of frequencies, the digital filter (440) being used for filtering out crosstalk signals in the impedance signal. The battery impedance measurement circuit (400) can effectively filter out crosstalk signals from a battery impedance signal, and is simple to implement.

FIG.4

**Description**

FIELD OF THE INVENTION

The present invention relates to the technical field of electronic circuits, in particular to a battery impedance measurement circuit.

BACKGROUND

For automotive electronics, accurate measurement of battery cell state is very important, and if the result is not accurate, it will lead to traffic safety problems. The effective way to obtain the state of battery cell is to measure the impedance of battery cell. However, it is difficult to accurately measure the impedance of the automotive battery, because the automotive battery tends to be relatively large battery pack, which comprising many different components, such as power line and multiple independent battery cells, and when the current flows through these components, the magnetic field generated by the current will cause additional interference to the measurement line in the impedance measurement circuit, and will lead to the crosstalk among multiple battery cells. Because the impedance of the automotive battery cell is very low, usually less than 1 m$\Omega$, the measurement signal in the impedance measurement circuit is on $\mu$V level, which belongs to the same order of magnitude as the crosstalk voltage induced by the magnetic field generated by the measurement current in the impedance measurement circuit. Therefore, the crosstalk voltage seriously interferes with the voltage signal used for impedance measurement, resulting in inaccurate impedance measurement results.

SUMMARY

The technical problem to be solved by the present invention is to provide a battery impedance measurement circuit which can simply and accurately remove crosstalk.

The technical solution adopted by the present invention to solve the above technical problems is a battery impedance measurement circuit, comprising: a signal generator, which is connected with at least one battery cell for inputting a drive current to each battery cell; an analog-to-digital converter, which is connected to the two ends of the battery cell to converting the analog voltage signal of the battery cell into a digital voltage signal; an impedance extraction module, which is connected to the signal generator and the analog-to-digital converter for extracting an impedance signal associated with the impedance characteristics of the battery cell; and a digital filter, which receives the impedance signal from the impedance extraction module, the digital filter having attenuation notches at a plurality of frequencies, and the digital filter being used for filtering out the crosstalk signal in the impedance signal.

In an embodiment of the present invention, the frequency of the drive current which is inputted into each battery cell by the signal generator is equal.

In an embodiment of the present invention, frequency intervals between the plurality of frequencies corresponding to the attenuation notches are equal.

In an embodiment of the present invention, a frequency interval between the drive current which is inputted by the signal generator to each battery cell is equal to a frequency interval between the plurality of frequencies corresponding to the attenuation notches.

In an embodiment of the present invention, the digital filter enables the DC component in the impedance signal to pass through.

In an embodiment of the present invention, the digital filter comprises a comb filter with attenuation notches at the plurality of frequencies.

In an embodiment of the present invention, the digital filter further comprises a low-pass filter.

In an embodiment of the present invention, frequency intervals between the plurality of frequencies corresponding to the attenuation notches are equal to the reciprocal of a measurement period.

In an embodiment of the present invention, the digital filter comprises an integrator, the integrator comprises an adder and a register, the impedance extraction module is connected with one input end of the adder, and the output end of the register is fed back to the other input end of the adder.

The battery impedance measurement circuit of the present invention by adopting a digital filter with attenuation notches at multiple frequencies, especially a comb filter combined with a low-pass filter, which can effectively filter out the crosstalk signal in the battery impedance signal, the realization mode is simple, and is helpful to obtain accurate battery impedance measurement results.

BRIEF DESCRIPTION OF THE DRAWINGS

In order to make the above-mentioned objects, features and advantages of the present invention more obvious and understandable, the following specific embodiments of the present invention are described in detail in conjunction with the accompanying drawings, wherein:

FIG. 1 is a schematic diagram of a battery impedance measurement circuit;
FIG. 2 is a schematic diagram of the principle of measuring the impedance of battery cell with impedance measurement device;
FIG. 3A and FIG. 3B are schematic diagrams of the crosstalk phenomenon caused by electromagnetic coupling of the battery impedance measurement device;
FIG. 4 is a schematic diagram of a battery impedance measurement circuit in an embodiment of the present invention;
FIG. 5 is a schematic diagram of amplitude-frequency characteristic curve of a digital filter in an embodiment of the present invention;
FIG. 6 is a schematic diagram of amplitude-frequency characteristic curve of a battery impedance measurement circuit in an embodiment of the present invention;
FIG. 7 is a circuit diagram of a digital filter in an embodiment of the present invention.

PREFERRED EMBODIMENTS OF THE INVENTION

In order to make the above-mentioned objects, features and advantages of the present invention more obvious and understandable, the following specific embodiments of the present invention are described in detail in conjunction with the accompanying drawings.

Many specific details are set forth in the following description to facilitate a full understanding of the present invention, but the present invention can also be implemented in other ways different from those described herein, so the present invention is not limited by the specific embodiments disclosed below.

As shown in the present invention and the claims, unless the context expressly indicates an exception, the words "a", "an", "a kind of" and/or "the" do not refer to the singular number specifically, but may also include the plural number. Generally speaking, the terms "including" and "comprising" only imply the inclusion of clearly identified steps and elements, which do not constitute an exclusive list, and methods or devices may also contain other steps or elements.

In the description of the present invention, it needs to be understood that the orientation or position relationship indicated by the orientation words such as "front, back, up, down, left, right", "cross, vertical, perpendicular, horizontal" and "top and bottom" are usually based on the orientation or position relationship shown in the attached drawings, which are only for the convenience of describing the present invention and simplifying the description. In the absence of any explanation to the contrary, these orientations do not indicate or imply that the device or element referred to must have a specific orientation or be constructed and operated in a specific orientation, so it cannot be understood as a restriction on the scope of protection of the present invention; the location words "inside and outside" refer to the inside and outside of the outline relative to each component itself.

In addition, it should be noted that the use of words such as "first" and "second" to define parts is only for the convenience of distinguishing corresponding parts. If there is no separate statement, the above words have no special meaning, so it cannot be understood as a restriction on the scope of protection of the present invention. In addition, although the terms used in the present invention are selected from the public terms, some terms mentioned in the specification of the present invention may be selected by the applicant according to his or her judgment, and their detailed meanings are explained in the relevant part of the description herein. In addition, it is required to understand the present invention not only by the actual terms used, but also by the meaning of each term.

It should be understood that when a part is referred to as "on another part", "connected to another part", "coupled to another part" or "contacting another part", it may be directly on top of, connected to or coupled to, or in contact with, the other part, or there may be an insert part. In contrast, when a component is referred to as "directly on another component", "directly connected to", "directly coupled to", or "directly in contact with" another component, there is no insertion component. Similarly, when the first component is referred to as "electrical contact" or "electrically coupled to" the second component, there is a circuit path between the first component and the second component that allows current to flow. The circuit path may include capacitors, coupled inductors and/or other components that allow current to flow, even without direct contact between conductive components.

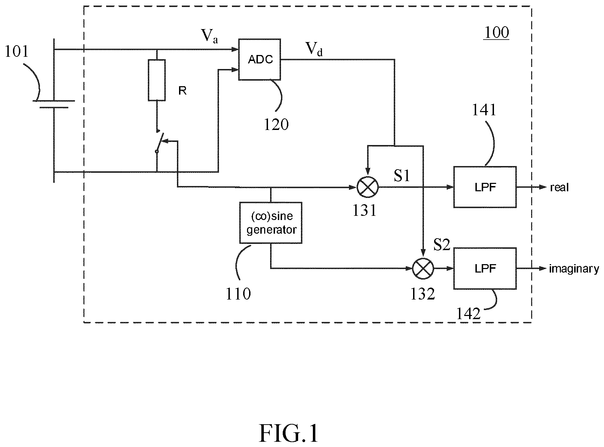

FIG. 1 is a schematic diagram of a battery impedance measurement circuit. Referring to FIG. 1, the measurement circuit 100 is used for measuring the impedance of the battery 101. In the measurement circuit 100, the signal generator 110 generates a drive current and drives the current flows into the battery 101. The signal generator 110 can be a sine/cosine wave generator, which can output two signals, one is sine signal and the other is cosine signal. The analog-to-digital converter 120 converts an analog voltage signal $V_a$ from the battery 101 into a digital voltage signal $V_d$. The digital voltage signal $V_d$ is multiplied by the output signal of the signal generator 110 by multiplier 131 and multiplier 132 to obtain two output signal S1 and output signal S2. The output signal S1 outputs the real part of impedance value (real) of the battery 101 through the low-pass filter (LPF) 141, and the output signal S2 outputs the imaginary part of impedance value (imaginary) of the battery 101 through the low-pass filter (LPF) 142. The measurement circuit 100 shown in FIG. 1 can also be referred to as a synchronous demodulator, which can realize the function of a band-pass filter. The measuring circuit 100 may be included in an impedance measurement device for measuring battery impedance.

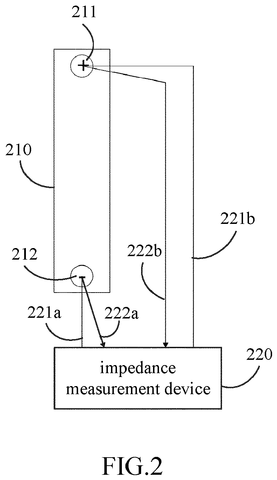

FIG. 2 is a schematic diagram of the principle of measuring the impedance of battery cell with impedance measurement device. Referring to FIG. 2, the battery cell 210 includes a positive electrode 211 and a negative electrode 212. In order to measure the impedance of the battery cell 210, the impedance measurement device 220 is connected to the battery cell 210. FIG. 2 shows a four-point measurement method, that is the impedance measurement device 220 is connected to the positive electrode 211 and the negative electrode 212 of the battery cell 210 by two drive wires 221a and 221b respectively, which are used for inputting the drive current to the battery cell 210; and the impedance measurement device 220 is connected to the positive electrode 211 and the negative electrode 212 of the battery cell 210 by two sense wires 222a and 222b respectively, which are used for measuring the voltage generated by the battery cell 210 in response to the drive current. In some examples, the drive wires 221a and 221b are also used for supplying current to the impedance measurement device 220. According to the impedance measurement device 220 shown in FIG. 2 and the four-point measurement method, it is possible to avoid introducing additional impedance of the measurement device when measuring the impedance of the battery cell 210.

What FIG. 2 shows is not used to limit the relative position of the impedance measurement device 220 with the battery cell 210. In some examples, the battery cell 210 may be rotated 90 degrees relative to the position shown in FIG. 2, that is the battery cell 210 is placed horizontally, and the positive electrode 211 and negative electrode 212 of the battery cell 210 are on the same horizontal line.

The battery cell 210 shown in FIG. 2 is also not limited to one battery cell 210, which may represent a combination of multiple battery cells 210.

In some embodiments, the same impedance measurement device can be used for measuring multiple battery cells simultaneously. A separate impedance measurement device can also be configured for each battery cell. The measurement principles can refer to FIG. 2 and its description.

This specification takes FIG. 2 as an example. In the embodiment shown in FIG. 2, the negative electrode 212 of the battery cell 210 is closer to the impedance measurement device 220 and the positive electrode 211 is farther away from the impedance measurement device 220. So that both the drive wire 221a and the sense wire 222a connected to the negative electrode 212 in the impedance measurement device 220 are relatively short, and both the drive wire 221b and the sense wire 222b connected to the positive electrode 211 are relatively long.

When the impedance of the battery is measured by the four-point measurement method shown in FIG. 2, the current flowing through the drive wire and the sense wire will generate a magnetic field. Because the drive wire 221a and the sense wire 222a are short, the influence of magnetic field on the drive wire 221a and the sense wire 222a is small, so the influence on the measurement results can be ignored. However, the magnetic field will produce coupling inductance on the long drive wire 221b and the long sense wire 222b, which will generate the induction voltage in the sense wire 222b, and further affect the impedance measurement results of the battery cell.

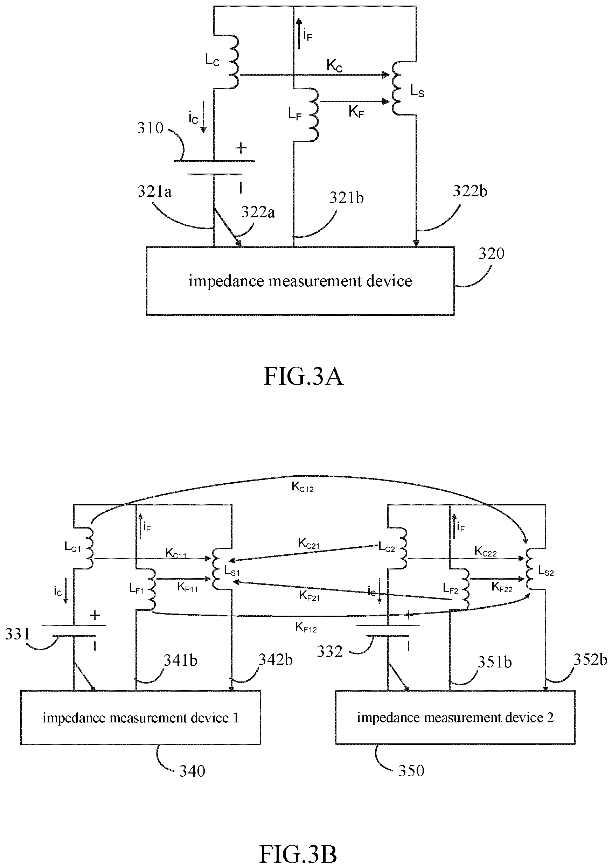

FIG. 3A and FIG. 3B are schematic diagrams of the crosstalk phenomenon caused by electromagnetic coupling of the battery impedance measurement device. As shown in FIG. 3A, the state of making impedance measurement of one battery cell is shown. In practice, the battery cell, the drive wire and the sense wire are all coupled by magnetic field, which induces the crosstalk voltage. However, the present invention mainly relates to the measurement of impedance of the battery, so it mainly focuses on the crosstalk to the sense wire, including the crosstalk caused by the battery cell to the sense wire and caused by the drive wire to the sense wire.

Referring to FIG. 3A, the battery cell 310 is equivalent to the battery cell 210 shown in FIG. 2. In FIG. 3A, the battery cell 310 represents one battery cell. The impedance measurement device 320 is used for measuring the impedance of the battery cell 310. The impedance measurement device 320 is connected with the positive electrode and the negative electrode of the battery cell 310 by two drive wires 321a and 321b, which are used for inputting the measurement current to the battery cell 310; and the impedance measurement device 320 is connected with the positive electrode and the negative electrode of the battery cell 310 by two sense wires 322a and 322b respectively, which are used for measuring the voltage of the battery cell 310. Referring to FIG. 3A, the battery inductive reactance $L_c$ represents the inductive reactance of the battery cell 310 under magnetic field coupling, the drive wire inductive reactance $L_F$ represents the inductive reactance of the drive wire 321b under magnetic field coupling, and the sense wire inductive reactance $L_S$ represents the inductive reactance of the sense wire 322b under magnetic field coupling. The coupling parameter $K_c$ represents the electromagnetic coupling generated by the battery cell 310 to the sense wire 322b, and the coupling parameter $K_F$ represents the electromagnetic coupling generated by the drive wire 321b to the sense wire 322b.

As shown in FIG. 3A, the crosstalk voltage $v_{ind}$ generated on the sense wire 322b is:

$$v_{ind} = jwi_C K_C \sqrt{L_C L_S} + jwi_F K_F \sqrt{L_F L_S} \qquad (1)$$

Wherein the $i_C$ is the current flowing through the battery cell 310 and the $i_F$ is the current on the drive wire 321b. Generally, as shown in FIG. 3A, the $i_C$ and the $i_F$ are equal in size and opposite in direction, that is $i_C = -i_F$. Therefore, the above formula (1) can be simplified as follows:

$$v_{ind} = jwi_C\left(K_C\sqrt{L_CL_S} - K_F\sqrt{L_FL_S}\right) \qquad (2)$$

According to formula (2), the crosstalk voltage only affects the imaginary part of impedance value in the impedance measurement results. In practice, the crosstalk voltage also has a certain influence to the real part of impedance value in the impedance measurement results, but it is not as obvious as the impact on the imaginary part of impedance value.

Although FIG. 3A only shows an impedance measurement state of one battery cell 310, in practical measurement, other battery cells adjacent to or close to the battery cell 310 may also be affected by the magnetic field generated by the impedance measurement device 320, resulting in interactive crosstalk. Multiple battery cells adjacent to or close to each other indicate that the multiple battery cells may be electrically connected to each other, and also may not be electrically connected to each other.

As shown in FIG. 3B, the battery cell 331 is adjacent to or close to the battery cell 332, the impedance measurement device 340 is used for measuring the impedance of the battery cell 331, and the impedance measurement device 350 is used for measuring the impedance of the battery cell 332.

As shown in FIG. 3B, when the impedance measurement device 340 is used for measuring the impedance of the battery cell 331, the inductive reactance of the battery cell 331 under magnetic field coupling is $L_{C1}$, the inductive reactance of the drive wire 341b under magnetic field coupling is $L_{F1}$, and the inductive reactance of the sense wire 342b under magnetic field coupling is Lsi. When the impedance measurement device 350 is used for measuring the impedance of the battery cell 332, the inductive reactance of the battery cell 332 under magnetic field coupling is $L_{C2}$, the inductive reactance of the drive wire 351b under magnetic field coupling is $L_{F2}$, and the inductive reactance of the sense wire 352b under magnetic field coupling is $L_{S2}$.

As shown in FIG. 3B, for the battery cell 331, the sense wire 342b in the impedance measurement device 340 is not only subjected to the electromagnetic coupling parameter $K_{C11}$ of the battery cell 331 and the electromagnetic coupling parameter $K_{F11}$ of the drive wire 341b in its own measurement circuit, but also the electromagnetic coupling parameter $K_{C21}$ from the battery cell 332 and the electromagnetic coupling parameter $K_{F21}$ from the drive wire 351b in the adjacent measurement circuit. For the battery cell 332, the sense wire 352b in the impedance measurement device 350 is not only subjected to the electromagnetic coupling parameter $K_{C22}$ of the battery cell 332 and the electromagnetic coupling parameter $K_{F22}$ of the drive wire 351b in its own measurement circuit, but also the electromagnetic coupling parameter $K_{C12}$ from the battery cell 331 and the electromagnetic coupling parameter $K_{F12}$ from the drive wire 341b in the adjacent measurement circuit.

For more battery cells and their corresponding impedance measurement devices, the measurement circuits will produce more complex crosstalk with each other. This kind of crosstalk has a serious impact on the impedance measurement results.

In order to remove the above-mentioned crosstalk, the battery cells can be divided into several groups, and only one battery cell in a group is measured at a time. For example, if the crosstalk generated by two battery cells adjacent to the battery cell to be measured is considered, then M = 3. Numbering the multiple battery cells sequentially, and taking each three battery cells as a group. Firstly, measuring the first battery cell in each group of the battery cells, that the battery cells numbered 1, 4, 7 and so on. Then measuring the second battery cell in each group of the battery cells, that the battery cells numbered 2, 5, 8 and so on. Although the method can eliminate the crosstalk, it takes a long time and two-thirds of the data extracted from each battery cell is lost.

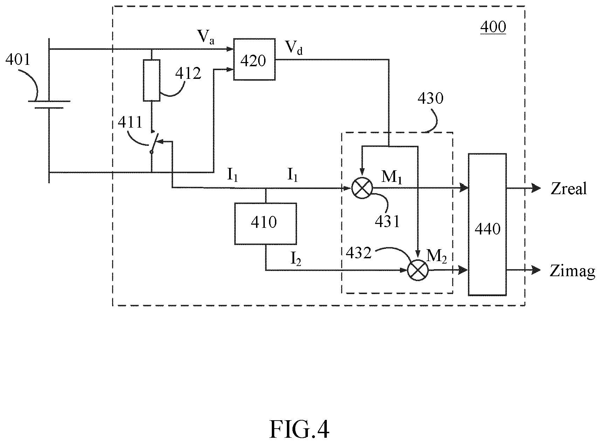

FIG. 4 is a schematic diagram of a battery impedance measurement circuit in an embodiment of the present invention. Referring to FIG. 4, the battery impedance measurement circuit 400 is connected with the battery cell 401 for measuring the impedance of the battery cell 401, and one battery cell 401 is shown in FIG. 4. In other embodiments, the battery impedance measurement circuit 400 may be connected with multiple battery cells for measuring the impedance of the multiple battery cells.

As shown in FIG. 4, the battery impedance measurement circuit 400 includes a signal generator 410, an analog-to-digital converter 420, an impedance extraction module 430 and a digital filter 440. Wherein the signal generator 410 is connected with at least one battery cell for inputting multiple drive currents $I_1$ into each battery cell. The battery cell 401 shown in FIG. 4 may be used for representing one battery cell, and may also be used for representing a combination of multiple battery cells.

In some embodiments, the signal generator 410 can be a sine-cosine wave generator, and the present invention does not limit the specific implementation method of the signal generator 410. The drive current $I_1$ is inputted by the signal generator 410 into the battery cell 401 may be a sine signal or a cosine signal.

In some embodiments, the frequency of the drive current is inputted by the signal generator 410 into each battery cell is equal. The present invention does not limit the frequency value of the drive current. Preferably, the range of the frequency of the drive current is from 8 kHz to 8 mHz.

In some embodiments, the frequency of the drive current which is inputted by the signal generator 410 into each battery cell may be unequal. In practice, the frequency of the drive current input into each battery cell may vary.

As shown in FIG. 4, the battery impedance measurement circuit 400 also includes a switch 411 and a discharge resistor 412 in parallel with the battery cell 401. Wherein the signal generator 410 is connected with the switch 411, and the switch 411 is used for turning on or turning off the connection between the battery cell 401 and the discharge resistor 412. The discharge resistor 412 acts as a current divider. In some embodiments, the signal generator 410 may also includes a modulator, such as a pulse density modulator, so that the sine/cosine signal generated by the signal generator 410 is modulated by the modulator and then inputted into the battery cell, and making the modulation signal to control the switch 411 to turn on or turn off the connection with the discharge resistor 412.

The analog-to-digital converter (ADC) 420 is connected with the two ends of the battery cell 401 for converting the analog voltage signal $V_a$ of the battery cell 401 into the digital voltage signal $V_d$. As shown in FIG. 4, the positive electrode and the negative electrode of the battery cell 401 are connected with the two input ends of the analog-to-digital converter 420 respectively.

In some embodiments, an analog filter circuit (not shown in figures) may also be included between the analog-to-digital converter 420 and the battery cell 401, which is used for filtering out the noise from the analog voltage signal $V_a$.

As shown in FIG. 4, the impedance extraction module 430 is connected with the signal generator 410 and the analog-to-digital converter 420, the signal generator 410 outputs the drive current signal into the input end of the impedance extraction module 430, and the analog-to-digital converter 420 outputs the digital voltage signal $V_d$ into the input end of the impedance extraction module 430. The impedance extraction module 430 can extract the impedance signal associated with the impedance characteristics of the battery cell 401 according to the received drive current signal and the digital voltage signal $V_d$.

In some embodiments, the impedance extraction module 430 includes a first multiplier 431 and a second multiplier 432. The drive current signal $I_1$ generated by the signal generator 410 is inputted into the input end of the first multiplier 431, and the drive current signal $I_2$ generated by the signal generator 410 is inputted into the input end of the second multiplier 432. Wherein the $I_1$ and the $I_2$ are sine signal and cosine signal respectively, that is, if the $I_1$ is sine signal, then the $I_2$ is the corresponding cosine signal; and if the $I_1$ is cosine signal, then the $I_2$ is the corresponding sine signal.

The result $M_1$ of multiplying the digital voltage signal $V_d$ and the drive current signal $I_1$ is inputted into the digital filter 440, and the real part of impedance value (Zreal) of the battery cell 401 can be outputted by the digital filter 440; the result $M_2$ of multiplying the digital voltage signal $V_d$ and the drive current signal $I_2$ is inputted into the digital filter 440, and the imaginary part of impedance value (Zimag) of the battery cell 401 can be outputted by the digital filter 440. The results of both $M_1$ and $M_2$ are impedance signals associated with the impedance characteristics of the battery cell 401.

Referring to FIG. 4, the digital filter 440 is connected to the impedance extraction module 430, and the digital filter 440 has attenuation notches at multiple frequencies, the digital filter 440 is used for filtering out the crosstalk signals from the impedance signals. The crosstalk signal here is the crosstalk signal on the sense wire of the impedance measurement device described above, which will cause inaccurate impedance measurement results of the battery cell. The attenuation notches at the multiple frequencies are used for filtering the signals of the multiple frequencies.

In the embodiment shown in FIG. 4, one digital filter 440 is connected to the impedance extraction module 430. And in other embodiments, multiple digital filters 440 may be included, such as including two digital filters 440, one of which is connected to the output end of the first multiplier 431 for outputting the real part of impedance value (Zreal) of the battery cell 401, and the other is connected to the output end of the second multiplier 432 for outputting the imaginary part of impedance value (Zimag) of the battery cell 401.

In some embodiments, the digital filter 440 enables the DC component in the impedance signal to pass through. The DC component of the impedance signal includes the impedance information of the battery cell 401.

In some embodiments, the digital filter 440 includes a comb filter with attenuation notches at multiple frequencies for filtering of specific frequency signals.

In some embodiments, the digital filter 440 includes a comb filter and a low-pass filter. The low-pass filter can be used to enable the DC component in the impedance signal to pass through and reduce the high frequency noise in the impedance signal as a whole. The high frequency noise may originate from outside of the battery impedance measurement circuit. When the battery impedance measurement circuit of the present invention is used for measuring the impedance of the automotive battery cell, the low-pass filter in the digital filter 440 of the present invention is also used for removing the high frequency noise from other components of the automobile, such as a motor.

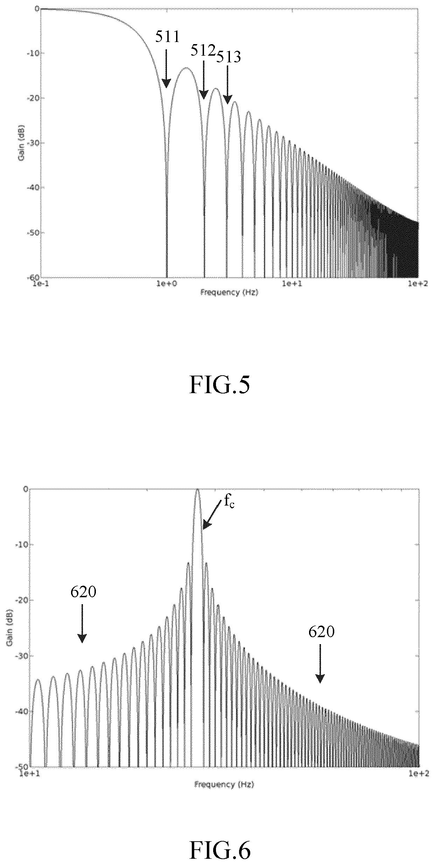

FIG. 5 is a schematic diagram of amplitude-frequency characteristic curve of a digital filter in an embodiment of the present invention. Wherein the horizontal axis is the frequency in Hertz (Hz) and displayed in exponential coordinates; and the longitudinal axis is the amplitude strength of the signal in decibels (dB). FIG. 5 shows the amplitude-frequency characteristic curve of digital filter combined with a comb filter and a first-order low-pass filter. Referring to FIG. 5, the amplitude-frequency characteristic curve indicates the digital filter is a low-pass filter which enables the DC component to pass through and has attenuation notches at multiple frequencies. For example, there is a first attenuation notch 511 at 1Hz, a second attenuation notch 512 at 2Hz, a third attenuation notch 513 at 3Hz, and so on. The frequency of the multiple attenuation notches corresponds to the frequency of the crosstalk signal. According to the digital filter, the crosstalk signal in the impedance signal of the battery cell can be accurately filtered out.

In the embodiment shown in FIG. 5, the frequency intervals between a plurality of frequencies with attenuation notches are equal, and the frequency interval is 1 Hz. FIG. 5 is only as an example, and in other embodiments, the frequency interval may be other values.

In some embodiments, the frequency interval between the frequencies of the drive current inputted by the signal generator 410 into each battery cell is equal to the frequency interval between the multiple frequencies corresponding to the attenuation notch. As shown in FIG. 5, if the frequency interval between multiple frequencies corresponding to the attenuation notch is 1 Hz, then the frequency interval between the drive current inputted by the signal generator 410 into each battery cell can also be 1 Hz. For example, there is a battery pack includes three battery cells, when measuring the impedance of one of the battery cells, the frequency of the drive current is inputted into the three battery cells can be 999Hz, 1000Hz and 1001Hz respectively, that is, the frequency interval between the frequency of the drive current is 1Hz.

The present invention does not limit the order and the cut-off frequency of the low-pass filter in the digital filter, and can provide a suitable low-pass filter according to the need. The low-pass filter combined with comb filter can achieve the purpose of accurately filtering out the crosstalk signal in the impedance signal. For example, the order of the low-pass filter is fourth-order and the cut-off frequency is 0.3Hz. It can be understood that the lower the cut-off frequency, the higher the order of the filter, the more obvious the signal attenuation, the greater the delay been generated, and the higher the cost of the filter.

FIG. 6 is a schematic diagram of amplitude-frequency characteristic curve of a battery impedance measurement circuit in an embodiment of the present invention. Wherein the horizontal axis is the frequency in Hertz (Hz) and displayed in exponential coordinates; the longitudinal axis is the amplitude strength of the signal in decibels (dB). Combined with FIG. 4 and FIG. 6 show the amplitude-frequency characteristic curve of the whole battery impedance measurement circuit 400. Referring to FIG. 6, the amplitude-frequency characteristic curve is expressed as the amplitude-frequency characteristic of a band-pass filter, and its center frequency $f_c$ is the measurement frequency of the battery cell whose impedance is to be measured, that is, the frequency of the drive current which is inputted by the signal generator into the battery cell. On both sides of the center frequency $f_c$, there are attenuation notches 620 at the multiple frequencies respectively, and the frequency interval of the multiple attenuation notches 620 are the same as those shown in FIG. 5, which are 1 Hz. FIG. 6 is only as an example, and in other embodiments, the frequency interval may be other values.

According to the embodiment shown in FIG. 6, the crosstalk signal in the impedance signal can be removed effectively by the battery impedance measurement circuit, so that the accurate impedance value can be acquired.

In some embodiments, the frequency interval between the multiple frequencies corresponding to the multiple attenuation notches is equal to the reciprocal of a measurement period. The measurement period refers to the period in which the battery impedance measurement circuit of the present invention is used for measuring the impedance of the battery cell. In the embodiments shown in FIG. 5 and FIG. 6, if the measurement period is 1 second, then the frequency interval of the multiple frequencies is 1 Hz. And in other embodiments, if the measurement period is 0.5 seconds, then the frequency interval of the multiple frequencies is 2 Hz.

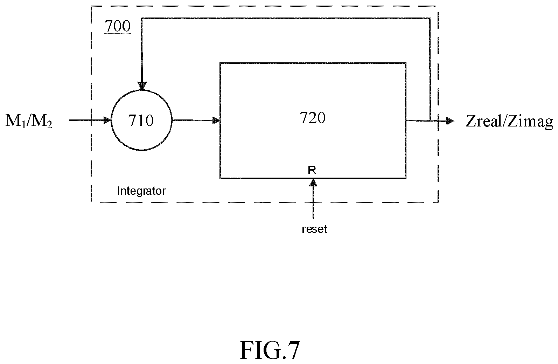

FIG. 7 is a circuit diagram of a digital filter in an embodiment of the present invention. The digital filter 700 may be the digital filter 440 in the battery impedance measurement circuit 400 shown in FIG. 4. Referring to FIG. 7, the digital filter 700 includes an adder 710 and a register 720, which together form an integrator. As shown in FIG. 4, the results $M_1$ and/or $M_2$ outputted by the impedance extraction module 430 are inputted into the input end of the adder 710, and the output end of the adder 710 is connected with the input end of the register 720, and the output end of the register 720 is fed back to the adder 710 as an input item of the adder 710, so that the function of the integrator can be realized. At the end of each measurement period, the register 720 is reset through the reset end of the register 720.

The amplitude-frequency characteristic of the digital filter 700 shown in FIG. 7 can be represented by the amplitude-frequency characteristic curve diagram shown in FIG. 5. That is the digital filter 700 shown in FIG. 7 is a digital filter combining a comb filter and a first-order low-pass filter.

The battery impedance measurement circuit according to the present invention can remove the crosstalk between multiple battery cells, and can simultaneously measure the impedance of multiple battery cells, and the realization method is simple.

Although the present invention has been described with reference to the current specific embodiment, the ordinary technical personnel in the technical field should realize that the above embodiments are only used for illustrating the present invention, and various equivalent changes or substitutions can be made without departing from the spirit of the present invention. Therefore, as long as the changes and variants of the above-mentioned embodiments within the

**EP 4 220 208 A1**

substantive spirit of the present invention will fall within the scope of the claims of the present invention.

**Claims**

1. A battery impedance measuring circuit, comprising:

   a signal generator, which is connected with at least one battery cell for inputting a drive current to each battery cell;
   an analog-to-digital converter, which is connected to the two ends of the battery cell to converting the analog voltage signal of the battery cell into a digital voltage signal;
   an impedance extraction module, which is connected to the signal generator and the analog-to-digital converter for extracting an impedance signal associated with the impedance characteristics of the battery cell; and
   a digital filter, which receives the impedance signal from the impedance extraction module, the digital filter having attenuation notches at a plurality of frequencies, and the digital filter being used for filtering out the crosstalk signal in the impedance signal.

2. The battery impedance measuring circuit according to claim 1, wherein the frequency of the drive current which is inputted into each battery cell by the signal generator is equal.

3. The battery impedance measuring circuit according to claim 1, wherein frequency intervals between the plurality of frequencies corresponding to the attenuation notches are equal.

4. The battery impedance measurement circuit according to claim 3, wherein a frequency interval between the drive current which is inputted by the signal generator to each battery cell is equal to a frequency interval between the plurality of frequencies corresponding to the attenuation notches.

5. The battery impedance measurement circuit according to claim 1, wherein the digital filter enables the DC component in the impedance signal to pass through.

6. The battery impedance measurement circuit according to claim 1, wherein the digital filter comprises a comb filter with attenuation notches at the plurality of frequencies.

7. The battery impedance measurement circuit according to claim 6, wherein the digital filter further comprises a low-pass filter.

8. The battery impedance measurement circuit according to claim 1, wherein frequency intervals between the plurality of frequencies corresponding to the attenuation notches are equal to the reciprocal of a measurement period.

9. The battery impedance measurement circuit according to claim 1, wherein the digital filter comprises an integrator, the integrator comprises an adder and a register, the impedance extraction module is connected with one input end of the adder, and the output end of the register is fed back to the other input end of the adder.

FIG.1

FIG.2

FIG.3A

FIG.3B

FIG.4

FIG.5

FIG.6

FIG.7

## INTERNATIONAL SEARCH REPORT

| International application No. |
|---|
| **PCT/CN2021/106829** |

| **A.** | **CLASSIFICATION OF SUBJECT MATTER** |
|---|---|

G01R 31/389(2019.01)i;  G01R 27/02(2006.01)i

According to International Patent Classification (IPC) or to both national classification and IPC

| **B.** | **FIELDS SEARCHED** |
|---|---|

Minimum documentation searched (classification system followed by classification symbols)

G01R

Documentation searched other than minimum documentation to the extent that such documents are included in the fields searched

Electronic data base consulted during the international search (name of data base and, where practicable, search terms used)

CNABS, CNTXT, ENTXTC, WPABSC, CNKI, WPABS, DWPI, VEN, OETXT: 电池, 内阻, 滤波, 数字, 带阻, 串扰, 梳, 陷波, 槽, 频率, 多, 扫频, internal, resistance, crosstalk, interference, frequency, filter, comb, lowpass, band-pass, band-stop

| **C.** | **DOCUMENTS CONSIDERED TO BE RELEVANT** | |
|---|---|---|

| Category* | Citation of document, with indication, where appropriate, of the relevant passages | Relevant to claim No. |
|---|---|---|
| Y | JP 2006266960 A (FURUKAWA BATTERY CO. LTD.) 05 October 2006 (2006-10-05) description paragraphs 0018-0023, 0031, 0036, figure 1 | 1-9 |
| Y | US 2010289479 A1 (UNIV SUSSEX) 18 November 2010 (2010-11-18) description paragraphs 0054, 0055, 0059-0062, figure 7 | 1-9 |
| Y | CN 1558253 A (CHAMPLIN KEITH S.) 29 December 2004 (2004-12-29) description, page 12 line 17 to page 14 line 15, figure 7 | 1-9 |
| Y | CN 102288830 A (ZheJiang Dawn Electrical Technology Co., Ltd.) 21 December 2011 (2011-12-21) description, paragraphs 0040-0042, figures 1, 2 | 1-9 |
| Y | JP 2006220629 A (FURUKAWA BATTERY CO. LTD.) 24 August 2006 (2006-08-24) description, paragraphs 0019-0026, figure 5 | 1-9 |
| Y | WO 9408396 A1 (COMMW SCIENT IND RES ORG et al.) 14 April 1994 (1994-04-14) description page 5 line 21 to page 7 line 16, figures 1, 2 | 1-9 |
| Y | CN 108267638 A (HITREND TECHNOLOGY (SHANGHAI) CO., LTD.) 10 July 2018 (2018-07-10) description, paragraph 0040 | 1-9 |

☑ Further documents are listed in the continuation of Box C.   ☑ See patent family annex.

| | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **14 October 2021** | **20 October 2021** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088 China** | |
| Facsimile No. **(86-10)62019451** | Telephone No. |

Form PCT/ISA/210 (second sheet) (January 2015)

## INTERNATIONAL SEARCH REPORT

| | International application No. |
|---|---|
| | **PCT/CN2021/106829** |

### C.    DOCUMENTS CONSIDERED TO BE RELEVANT

| Category* | Citation of document, with indication, where appropriate, of the relevant passages | Relevant to claim No. |
|---|---|---|
| Y | US 4940944 A (WESTINGHOUSE ELECTRIC CORP.) 10 July 1990 (1990-07-10) description, column 2, line 58 to column 3, line 13, and figure 1 | 1-9 |
| A | US 9698809 B1 (SCHWEITZER ENGINEERING LAB INC et al.) 04 July 2017 (2017-07-04) entire document | 1-9 |
| A | WO 2005010543 A1 (KONINKL PHILIPS ELECTRONICS NV et al.) 03 February 2005 (2005-02-03) entire document | 1-9 |

Form PCT/ISA/210 (second sheet) (January 2015)

## INTERNATIONAL SEARCH REPORT
### Information on patent family members

| International application No. |
|---|
| **PCT/CN2021/106829** |

| Patent document cited in search report | | | Publication date (day/month/year) | Patent family member(s) | | | Publication date (day/month/year) |
|---|---|---|---|---|---|---|---|
| JP | 2006266960 | A | 05 October 2006 | None | | | |
| US | 2010289479 | A1 | 18 November 2010 | GB | 2453099 | A | 01 April 2009 |
| | | | | EP | 2174416 | A1 | 14 April 2010 |
| | | | | WO | 2009010735 | A1 | 22 January 2009 |
| | | | | TW | 200913465 | A | 16 March 2009 |
| | | | | TW | I528707 | B | 01 April 2016 |
| | | | | EP | 2174416 | B1 | 09 December 2015 |
| | | | | US | 8860401 | B2 | 14 October 2014 |
| | | | | GB | 0714090 | D0 | 29 August 2007 |
| CN | 1558253 | A | 29 December 2004 | DE | 69941720 | D1 | 07 January 2010 |
| | | | | AU | 6245699 | A | 03 April 2000 |
| | | | | JP | 2002525586 | A | 13 August 2002 |
| | | | | CN | 1325551 | A | 05 December 2001 |
| | | | | EP | 1119882 | A1 | 01 August 2001 |
| | | | | WO | 0016428 | A9 | 26 October 2000 |
| | | | | US | 6002238 | A | 14 December 1999 |
| | | | | EP | 1119882 | A4 | 18 September 2002 |
| | | | | US | 6172483 | B1 | 09 January 2001 |
| | | | | CN | 100410678 | C | 13 August 2008 |
| | | | | EP | 1119882 | B1 | 25 November 2009 |
| | | | | WO | 0016428 | A1 | 23 March 2000 |
| CN | 102288830 | A | 21 December 2011 | None | | | |
| JP | 2006220629 | A | 24 August 2006 | None | | | |
| WO | 9408396 | A1 | 14 April 1994 | AU | 5144593 | A | 26 April 1994 |
| CN | 108267638 | A | 10 July 2018 | None | | | |
| US | 4940944 | A | 10 July 1990 | CA | 2009901 | A1 | 16 August 1990 |
| US | 9698809 | B1 | 04 July 2017 | None | | | |
| WO | 2005010543 | A1 | 03 February 2005 | EP | 1697755 | A1 | 06 September 2006 |
| | | | | US | 2008309329 | A1 | 18 December 2008 |
| | | | | SG | 128943 | A1 | 26 February 2007 |

Form PCT/ISA/210 (patent family annex) (January 2015)